# EUROPÄISCHE PATENTSCHRIFT

(11) **EP 1 186 901 B1**
(45) Veröffentlichungstag und Bekanntmachung des Hinweises auf die Patenterteilung: **14.02.2007**
(21) Anmeldenummer: 01115838.3
(22) Anmeldetag: 28.06.2001
(51) Int. Cl.: G11C 29/00

(54) **Verfahren und Vorrichtung zur Erzeugung digitaler Signalmuster**
Method and device for generating digital signal pattern
Procédé et dispositif pour générer des traces de signal digitales

(30) Priorität: 18.07.2000 DE 10034854
(43) Veröffentlichungstag der Anmeldung: 13.03.2002
(73) Patentinhaber: Infineon Technologies AG, 81669 München (DE)
(72) Erfinder: Ernst, Wolfgang, 81541 München (DE); Krause, Gunnar, 81541 München (DE); Kuhn, Justus, 81373 München (DE); Luepke, Jens, 81829 München (DE); Mueller, Jochen, 81825 München (DE); Poechmueller, Peter, 81739 München (DE); Schittenhelm, Michael, 85586 Poing (DE)
(74) Vertreter: Müller - Hoffmann & Partner

(56) Entgegenhaltungen:
- EP-A- 0 880 097
- US-A- 4 586 181
- US-A- 6 009 546
- US-A- 6 014 764
- US-A- 6 073 263

## Beschreibung

Die Erfindung betrifft ein Verfahren und eine Vorrichtung zur Erzeugung elektrischer digitaler Signalmuster gemäß den Oberbegriffen der nebengeordneten Patentansprüche 1 und 10. Ein solches Verfahren und eine derartige Vorrichtung sind aus US 6 073 263 bekannt.

Bislang werden digitale Signalmuster aus einer vorgegebenen Menge von zur Verfügung stehenden Einzelsignalen zum Beispiel für den Test schneller dynamischer Digitalschaltungen, wie SDRAM-Speicherbausteinen prinzipiell durch zwei unterschiedliche Verfahren erzeugt. Entweder werden die Signale bzw. Signalmuster mittels eines Algorithmus erzeugt und quasi online zur Verfügung gestellt oder in der später benötigten Reihenfolge vorab zur Verfügung gestellt. Das erste Verfahren ist aufwendig und kann, wenn eine hohe Frequenz bei der Erzeugung der Signalmuster gewünscht ist, zeitlich problematisch sein. Hierzu wird eine Vorrichtung benötigt, die den vorgegebenen Algorithmus in die Signalmuster umsetzt und mit der gewünschten Frequenz ausgibt.

Sollen mit dem zweiten Verfahren die Signalmuster bereits in der endgültigen Form bereitgestellt werden, so müssen diese zwischengespeichert werden. Dazu ist unter Umständen ein sehr großer Speicher nötig.

In einer Reihe von zu dieser Patentanmeldung parallelen Patentanmeldungen stellen die Erfinder das Konzept eines speziell für den Produktionstest von schnellen Speicherbausteinen geeigneten, von einem herkömmlichen Testgerät abgesetzten Halbleiterbausteins, eines sogenannten BOST-Bausteins (Built Outside Self Test) vor, der so konzipiert ist, dass er als kleiner und kostengünstiger ASIC-Baustein realisiert werden kann und die für den Speichertest benötigten Adressen-, Daten-, Takt- und Steuersignale in unmittelbarer Nähe und in Zuordnung zu einem getesteten oder zu testenden Speicherbaustein erzeugen und zur Verfügung stellen kann. Ein derartiger BOST-Baustein arbeitet mit der hohen Takt- und Signalfrequenz des Speicherbausteins und ermöglicht, dass die bislang zur Verfügung stehenden mit niedrigerer Frequenz arbeitenden Testsysteme weiter verwendet werden können. In einem derartigen BOST-Baustein ist jedoch eine den für die Signalmustererzeugung nach dem ersten Verfahren benötigten Algorithmus realisierende Vorrichtung oder ein zur Durchführung des zweiten obengenannten Verfahrens benötigter großvolumiger Speicher nur schwer und mit erhöhten Kosten für den Baustein unterzubringen.

US 6 014 764 A beschreibt ein Verfahren und eine Vorrichtung zur Erzeugung von Testvektoren. Musterdaten sind in einem lokalen Speicher abgelegt und werden durch Adressierung des Speichers mit Hilfe einer Adresssteuerung ausgelesen und ausgegeben. In dieser Druckschrift wird weiter ausgeführt, dass ein Block (= "Signalmustergruppe") von Musterdaten (= "Signalmuster") in benachbarten Speicherplätzen ein Pattern" genannt wird. Eine sogenannte "Pattern chaining definition" für einen Satz der als Pattern bezeichneten Muster gibt die Reihenfolge an, in der diese Muster aus dem Speicher ausgelesen werden. Diese Pattern Chaining Definition kann als sogenannte Patternlist augebaut und im selben Speicher abgespeichert sein. Mit Hilfe dieser Patternlist lassen sich die Muster aneinanderketten oder einzelne Muster in Schleifenwiederholungen mehrfach ausgeben. In der Patternlist sind jedoch nicht die Muster selber gespeichert, sondern die 30 Bit breiten Zeigeradressen, die im Speicher angeben, wo der Musterbereich beginnt und endet.

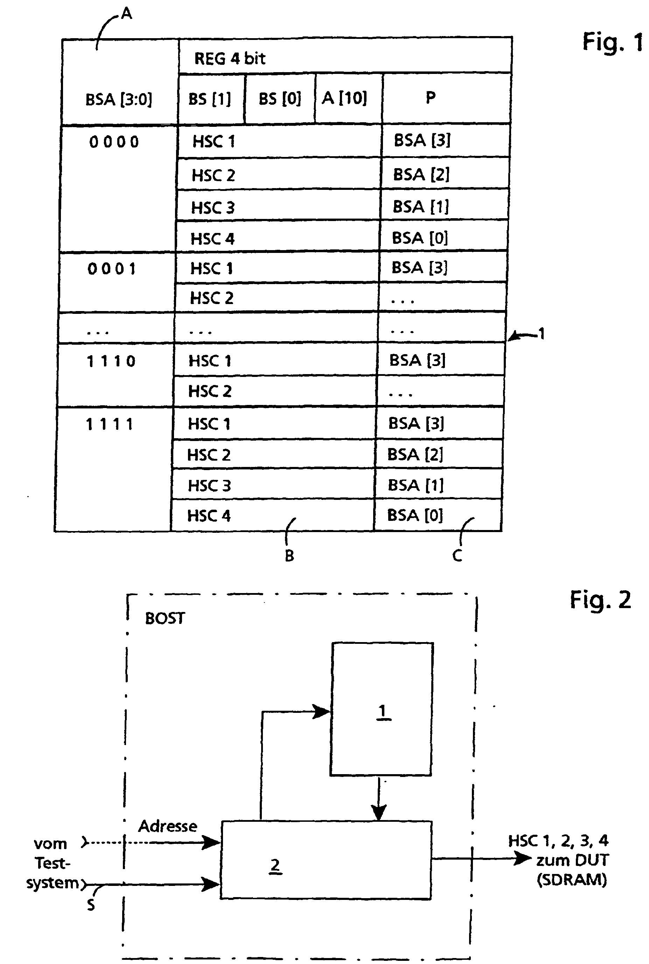

Die eingangs erwähnte US-A-6,073,263 beschreibt einen Mustergenerator zur Erzeugung von parallelen Signalmustern bzw. Signalmustergruppen für ein Testgerät zum Test integrierter Schaltungen. Unter Hinweis auf Figur 2 beschreibt diese Druckschrift in Spalte 5 ab Zeile 62 und Spalte 6 bis Zeile 9 in Kombination mit der Tabelle 1 in den Spalten 11 und 12, dass durch einen Host-Prozessor in dem in Figur 2 gezeigten Programmspeichers unter einer jeweiligen Adresse eine Folge von Signalmustern mit unterschiedlichen Funktionen gespeichert wird. Eines dieser Signalmuster ist ein Adressmuster, das eine nachfolgende Programmspeicheradresse des Programmspeichers bezeichnet. Ein anderes unter derselben Adresse gespeichertes Signalmuster "instruct" gibt einen Operationscode an, der einer als Mikroprozessor gestalteten "next cycle circuit" 34 eine andere Adresse im Programmspeicher als die oben genannte folgende Programmspeicheradresse befiehlt. In diesem Fall wird das die folgende Programmspeicheradresse bezeichnende Signalmuster übergangen und eine andere Adresse angesprungen, die durch die "next cycle circuit" 34 angegeben wird. Somit entspricht das Signalmuster "instruct" gemäß der Tabelle 1 der Druckschrift dem von außen zugeführten Steuersignal, da es in der "next cycle circuit" zur Erzeugung einer Sprungadresse führt.

Es ist deshalb Aufgabe der Erfindung, ein gattungsgemäßes Verfahren zur Erzeugung von digitalen Signalmustern und eine zur Durchführung dieses Verfahrens eingerichtete Vorrichtung so zu ermöglichen, dass die Kombinationsmöglichkeiten bei der Signalmustererzeugung möglichst groß und dabei weder algorithmische Systeme noch ein aufwendiger Speicher notwendig sind.

Die obige Aufgabe wird gemäß Anspruch 1 gelöst durch ein Verfahren zur Erzeugung digitaler elektrischer Signalmuster einer bestimmten Funktion, z. B. Datensignalmuster, bei dem in einem adressierbaren Speicher eine Vielzahl Signalmustergruppen, die jeweils eine Vielzahl unterschiedlicher Signalmuster HSC1, HSC2, HSC3, HSC4 derselben Funktion enthalten, gebildet und die Signalmuster der Signalmustergruppen jeweils unter einer der jeweiligen Signalmustergruppe eigenen Adresse vorab im Speicher gespeichert und auf eine entsprechende Adressierung hin ausgelesen und zur Verfügung gestellt werden, wobei im Speicher außerdem eine eine Auslesereihenfolge der gespeicherten Signalmustergruppen bestimmende Definition gespeichert wird, die Signalmuster und die Signalmustergruppen im Speicher aufeinanderfolgend gespeichert werden, und die die Auslesereihenfolge bestimmende Definition durch eine im Speicher unter derselben Adresse BSA wie jede gespeicherte Signalmustergruppe vorab gespeicherte Sprungadresse P angegeben ist, die eine Speicherposition für eine aus dem Speicher als nächste auszulesende Signalmustergruppe zuordnet, wobei jeweils ein gleicher Teil der die Sprungadresse P definierenden Bits BSA[3], BSA[2], BSA [1], BSA [0] zusammen mit jeweils einem der Signalmuster HSC1, HSC2, HSC3, HSC4 einer jeden Signalmustergruppe abgespeichert wird, so dass nach komplettem Durchlauf der Signalmustergruppe die gesamte Sprungadresse P zur Verfügung gestellt wird, und dass abhängig von der jeweils aktuellen Adresse BSA und von einem von außen zugeführten Steuersignal S entweder die Signalmuster der aktuellen Signalmustergruppe in der durch die fortlaufende Adresse bzw. ihre Speicherfolge angegebenen Reihenfolge oder in einer durch die jeweilige Sprungadresse P bestimmten Reihenfolge aus dem Speicher ausgelesen werden.

Bei dem erfindungsgemäßen Verfahren werden die Signalmuster in Gruppen in einem sehr kleinen Zwischenspeicher (Register) abgelegt. Zusammen mit jeder Gruppen von Signalmustern wird auch die Position einer folgenden Gruppe von Signalmustern abgelegt, die - in Abhängigkeit von dem zusätzlichen Steuersignal - ausgegeben wird. Das Steuersignal kann dabei ein einfaches digitales Ja-Nein-Signal sein.

Mit dem erfindungsgemäßen Verfahren können folgende Varianten realisiert werden:
(a) Ist das Steuersignal nicht aktiv, wird fortlaufend der Inhalt der aktuell adressierten Gruppe von Signalmustern ausgegeben.
(b) Außerdem können bei nicht aktivem Steuersignal jeweils die Signalmuster der direkt folgenden Gruppe von Signalmustern ausgegeben werden. Nach der Ausgabe der letzten Signalmustergruppe wird mit der ersten Signalmustergruppe fortgefahren.
(c) Bei aktiviertem Steuersignal wird nach der vollständigen Ausgabe der akteullen Signalmuster (mit der aktuellen Adresse adressiert) ein Sprung zum Anfang der durch die Sprungadresse (Pointer) angegebenen folgenden Signalmustergruppe ausgeführt. Diese Signalmustergruppe wird dann (in Abhängigkeit vom Zustand des Steuersignals) solange wiederholt ausgegeben wie das Steuersignal aktiv ist. Wenn das Steuersignal nicht mehr aktiv ist, wird diese Signalmustergruppe wieder verlassen und zum Beispiel mit der nächstfolgenden oder mit der ersten gespeicherten Signalmustergruppe fortgefahren.

Bei einer bevorzugten Verwendung des Verfahrens zur Ausgabe einer Folge von 3-bit-Signalmustern für die Bank-Select-Signale beim Test schneller dynamischer Halbleiterspeicherbausteine, insbesondere 256M SDRAMs, die vier Speicherbänke haben, weist jede durch eine Adresse angegebene Signalmustergruppe die gleiche Anzahl von Signalmustern, zum Beispiel vier Signalmuster auf. Alternativ kann jede Signalmustergruppe auch eine unterschiedliche Anzahl von Signalmustern haben.

Eine zur Durchführung des erfindungsgemäßen Verfahrens eingerichtete Vorrichtung nach Anspruch 10 zeichnet sich durch eine mit eine Zwischenspeicherregister, welches zur Speicherung der genannten Signalmustergruppen und der Sprungadresse verwendet wird, verbundene Steuerlogikschaltung zur Adressierung des Zwischenspeicherregisters und zum Empfang des genannten Steuersignals aus. Eine derartige relativ einfache, wenig Chipfläche belegende und kostengünstige Vorrichtung kann in einem von einem herkömmlichen Testgerät abgesetzten integrierten BOST-Halbleiterbaustein realisiert werden und für den Test schneller dynamischer Digitalschaltungen, wie zum Beispiel SDRAMs, zur Erzeugung von Adressen z.B. Bank-Select-Signalen dienen.

Die nachstehende Beschreibung beschreibt unter Bezug auf die Zeichnung ein Ausführungsbeispiel des erfindungsgemäßen Verfahren und der erfindungsgemäßen Vorrichtung, realisiert in einem BOST-Halbleiterbaustein für den Test schneller Halbleiterspeicher.
- Fig. 1: zeigt schematisch eine beispielhafte Speicherorganisation eines zur Speicherung von Signalmustergruppen verwendeten kleinen Zwischenspeicherregisters,
- Fig. 2: zeigt in Form eines Blockschaltbildes das in Fig. 1 gezeigte Zwischenspeicherregister in Verbindung mit einer Steuerlogikschaltung.

Fig. 1 zeigt tabellarisch die Speicherorganisation eines zur Durchführung des erfindungsgemäßen Verfahrens konzipierten Zwischenspeicherregisters 1, angewendet für die Erzeugung von 3-bit-Bank-Select-Signalen für den Test von 256M SDRAMs, die vier Speicherbänke haben. In das Zwischenspeicherregister 1 sind unter den in Spalte A angegebenen sechzehn 4-Bit-Adressen 0000-1111 in Spalte B sechzehn drei Bitstellen BS[1], BS[0], A[10] aufweisende Signalmustergruppen mit jeweils einer Folge von vier Mustern HSC1, HSC2, HSC3 und HSC4 gespeichert. In der letzten Spalte C ist eine Sprungadresse P für eine folgende Signalmustergruppe auf eine Adresse in Spalte A angegeben, zu der, wenn das Steuersignal S aktiviert ist, gesprungen wird.

Somit ergibt sich die Sprungadresse P nach dem kompletten Durchlauf der jeweils aktuellen Signalmustergruppe aus der Kombination aller jeweils zusammen mit den Signalmustern gespeicherten Anteilen BSA[0], ... BSA[3] der Sprungadresse P. Da hier von der Sprungadresse P nur 16 unterschiedliche Adressen adressiert werden, reicht es jeweils ein Bit für jeden Anteil BSA[0], ... BSA[3] der Sprungadresse P zu speichern.

Auf diese Weise ermöglicht das erfindungsgemäße Verfahren für den Test eines SDRAMs Signalmuster die drei Bitstellen umfassenden Bank-Select-Signale periodisch auszugeben, wobei sich, wenn das Steuersignal S nicht aktiviert ist, die unter der aktuell ausgewählten Adresse, zum Beispiel BSA = 0000 gespeicherten Signalmuster, zum Beispiel HSC1, HSC2, HSC3 und HSC4 zyklisch wiederholen.

Bei der erwähnten alternativen Verfahrensweise wird, wenn das Steuersignal nicht aktiv ist, der Inhalt der jeweils direkt folgenden Gruppe der Signalmuster ausgegeben. Nach Ausgabe der Signalmuster der letzten Gruppe wird mit der ersten Gruppe fortgefahren.

Wenn das Steuersignal S aktiviert ist, erfolgt nach der vollständigen Ausgabe der durch die aktuelle Adresse ausgewählten Signalmustergruppe ein Sprung zum Anfang der durch die in Spalte C gespeicherte Sprungadresse P angegebenen folgenden Gruppe. Diese kann dann in Abhängigkeit vom Steuersignal ebenfalls zyklisch wiederholt ausgelesen bzw. verlassen werden.

Fig. 2 ist ein Ausführungsbeispiel einer in Form einer BOST-Lösung konzipierten erfindungsgemäßen Vorrichtung und zeigt schematisch als Blockschaltbild ein in einem BOST-Baustein (BOST: Build Outside Self Test) implementiertes Zwischenspeicherregister 1 in Verbindung mit einer Steuerlogikschaltung 2. Die Adresse BSA zur aktuellen Auswahl einer jeweiligen Signalmustergruppe im Zwischenspeicherregister 1 kann im BOST-Baustein erzeugt oder von außen von einem Testsystem zugeführt werden. Vom Testsystem wird ebenfalls das Steuersignal S zugeführt. Die mit der erfindungsgemäßen Vorrichtung erzeugten Signalmuster HSC 1, 2, 3, 4 werden zu einem zu testenden digitalen Halbleiterschaltkreis DUT, zum Beispiel einem SDRAM geführt.

Es ist zu bemerken, dass das erfindungsgemäße Verfahren und die erfindungsgemäße Vorrichtung lediglich beispielhaft in einer Anwendung beschrieben wurden, bei der drei Bit umfassend Bank-Select-Signalmuster in Abhängigkeit von einer aktuellen Adresse BSA (in Fig. 1) und einem Steuersignal S im Zwischenspeicherregister 1 ausgewählt werden.

Das erfindungsgemäße Verfahren läßt sich jedoch auch zur periodischen Erzeugung von Signalmustern für andere Anwendungsfälle verwenden. Lediglich beispielhaft sei hier auf eine Anwendung des erfindungsgemäßen Verfahrens zur Erzeugung von Signalmustern für zyklisch zu variierende Datensignale, Steuersignale usw. beim Test von schnellen Halbleiterspeicherbausteinen hingewiesen

Nach dem oben Gesagten betrifft das erfindungsgemäße Verfahren und die erfindungsgemäße Vorrichtung ein System zur Erzeugung von digitalen elektrischen Signalmustern aus einer vorgegebenen Menge von zur Verfügung stehenden Einzelsignalen, wobei weder aufwendige algorithmische Systeme noch aufwendige. Speicher notwendig sind. Statt dessen realisiert die Erfindung eine derartige Signalmustererzeugung mit einem minimalen Registerumfang und einer einfachen Steuerlogik.

## Patentansprüche

1. Verfahren zur Erzeugung digitaler elektrischer Signalmuster einer bestimmten Funktion, z. B. Datensignalmuster, bei dem in einem adressierbaren Speicher (1) eine Vielzahl Signalmustergruppen, die jeweils eine Vielzahl unterschiedlicher Signalmuster (HSC1, HSC2, HSC3, HSC4) enthalten, gebildet und die Signalmuster der Signalmustergruppen jeweils unter einer der jeweiligen Signalmustergruppe eigenen Adresse vorab im Speicher (1) gespeichert und auf eine entsprechende Adressierung hin ausgelesen und zur Verfügung gestellt werden, wobei im Speicher außerdem eine eine Auslesereihenfolge der gespeicherten Signalmustergruppen bestimmende Definition gespeichert wird,
die Signalmuster und die Signalmustergruppen im Speicher (1) aufeinanderfolgend gespeichert werden, und die die Auslesereihenfolge bestimmende Definition durch eine im Speicher (1) unter derselben Adresse (BSA) wie jede gespeicherte Signalmustergruppe vorab gespeicherte Sprungadresse (P) angegeben ist, die eine Speicherposition für eine aus dem Speicher (1) als nächste auszulesende Signalmustergruppe zuordnet, und
wobei abhängig von der jeweils aktuellen Adresse (BSA) und von einem von außen zugeführten Steuersignal (S) entweder die Signalmuster der aktuellen Signalmustergruppe in der durch die fortlaufende Adresse bzw. ihre Speicherfolge angegebenen Reihenfolge oder in einer durch die jeweilige Sprungadresse Steuerlogikschaltung (2) das Steuersignal (S) und die aktuelle Adresse (BSA) empfängt und das Zwischenspeicherregister (1) ansteuert.

2. Verfahren nach Anspruch 1,
**dadurch gekennzeichnet, dass**
jede durch eine Adresse angegebene Signalmustergruppe die gleiche Anzahl von Signalmustern enthält.

3. Verfahren nach Anspruch 1 oder 2,
**dadurch gekennzeichnet, dass** jede durch eine Adresse angegebene Signalmustergruppe vier Signalmuster aufweist.

4. Verfahren nach Anspruch 1,
**dadurch gekennzeichnet, dass**
einige oder alle Signalmustergruppen eine unterschiedliche Anzahl von Signalmustern enthalten.

5. Verfahren nach einem der vorangehenden Ansprüche,
**dadurch gekennzeichnet, dass**
jedes Signalmuster drei Bitstellen hat. (P) bestimmten Reihenfolge aus dem Speicher (1) ausgelesen werden, **dadurch gekennzeichnet, dass** die Signalmuster (HSC1, HSC2, HSC3, HSC4) Signalmuster derselben Funktion sind, und dass jeweils ein gleicher Teil der die Sprungadresse (P) definierenden Bits (BSA[3], BSA[2], BSA[1], BSA[0]) zusammen mit jeweils einem der Signalmuster (HSC1, HSC2, HSC3, HSC4) einer jeden Signalmustergruppe abgespeichert wird, so dass nach komplettem Durchlauf der Signalmustergruppe die gesamte Sprungadresse (P) zur Verfügung gestellt wird.

6. Verfahren nach einem der vorangehenden Ansprüche,
**dadurch gekennzeichnet, dass**
wenn das Steuersignal (S) nicht aktiviert ist, fortlaufende Signalmuster der aktuell adressierten Signalmustergruppe ausgegeben werden.

7. Verfahren nach einem der Ansprüche 1 bis 5,
**dadurch gekennzeichnet, dass**
wenn das Steuersignal (S) nicht aktiviert ist, fortlaufend die gespeicherten Signalmustergruppen in der durch die fortlaufende Adressierung bzw. ihre Speicherfolge angegebenen Reihenfolge ausgegeben werden und dass nach Ausgabe des letzten Signalmusters mit der Ausgabe des ersten Signalmusters der ersten Signalmustergruppe fortgefahren wird.

8. Verfahren nach einem der Ansprüche 1 bis 5,
**dadurch gekennzeichnet, dass**,
wenn das Steuersignal (S) aktiviert ist, nach der vollständigen Ausgabe der aktuell adressierten Signalmustergruppe der Sprung zum Anfang der durch die Sprungadresse (P) zugeordneten nächsten Signalmustergruppe erfolgt.

9. Verwendung des Verfahrens nach einem der Ansprüche 1 bis 8 zur Ausgabe einer Folge von Dreibit-Signalmustern für die Bank-Select-Signale beim Test schneller dynamischer Halbleiterspeicherbausteine, insbesondere 256 M SDRAMs mit vier Speicherbänken.

10. Vorrichtung zur Durchführung des Verfahrens nach einem der Ansprüche 1 bis 8,
**gekennzeichnet durch**
eine mit einem Zwischenspeicherregister (1), das als der adressierbare Speicher zur Speicherung der Signalmuster der Signalmustergruppen und der Sprungadresse (P) eingerichtet ist, verbundene Steuerlogikschaltung (2) zur Erzeugung von Adressen für das Zwischenspeicherregister (1), wobei die

11. Vorrichtung nach Anspruch 10,
**dadurch gekennzeichnet, dass**
sie in einer von einem herkömmlichen Testgerät abgesetzten integrierten Halbleiterschaltung (BOST) für den Test von schnellen dynamischen Digitalschaltungen, insbesondere SDRAM-Speicherbausteinen zur Erzeugung von Bank-Select-Signalen vorgesehen ist.

## Claims

1. Method for generating digital electrical signal patterns for a specific function, e.g. data signal patterns, in which a multiplicity of signal pattern groups which each contain a multiplicity of different signal patterns (HSC1, HSC2, HSC3, HSC4) are formed in an addressable memory (1), and the signal patterns of the signal pattern groups are each stored in advance in the memory (1) at an address which is peculiar to the respective signal pattern group, and are read out in response to corresponding addressing and made available, a definition which determines a reading out sequence of the stored signal pattern groups also being stored in the memory, the signal patterns and the signal pattern groups being stored in sequence in the memory (1) and the definition which determines the reading out sequence being given by a branch address (P) which is stored in advance in the memory (1) at the same address (BSA) as any stored signal pattern group and which assigns a memory position for a subsequent signal pattern group which is to be read out of the memory (1), and either the signal patterns of the current signal pattern group being read out of the memory (1) as a function of the respective current address (BSA) and of a control signal (S) fed in from the outside, in the sequence given by the serial address or its memory sequence or in a sequence determined by the respective branch address (P), **characterized in that** the signal patterns (HSC1, HSC2, HSC3, HSC4) are signal patterns of the same function, and **in that** in each case an identical part of the bits (BSA[3], BSA[2], BSA[1], BSA[0]) which define the branch address (P) is stored together with in each case one of the signal patterns (HSC1, HSC2, HSC3, HSC4) of each signal pattern group so that the entire branch address (P) is made available after each complete run through the signal pattern group.

2. Method according to Claim 1, **characterized in that** each signal pattern group given by an address contains the same number of signal patterns.

3. Method according to Claim 1 or 2, **characterized in that** each signal pattern group given by an address has four signal patterns.

4. Method according to Claim 1, **characterized in that** some or all of the signal pattern groups contain a different number of signal patterns.

5. Method according to one of the preceding claims, **characterized in that** each signal pattern has three bit places.

6. Method according to one of the preceding claims, **characterized in that** if the control signal (S) is not activated, continuous signal patterns of the currently addressed signal pattern group are output.

7. Method according to one of Claims 1 to 5, **characterized in that** if the control signal (S) is not activated, the stored signal pattern groups are output continuously in the order given by the serial addressing or their memory sequence, and **in that**, after the last signal pattern has been output, the process is continued with the outputting of the first signal pattern of the first signal pattern group.

8. Method according to one of Claims 1 to 5, **characterized in that** if the control signal (S) is activated, the branching to the start of next year signal pattern group assigned by the branch address (P) takes place after the outputting of the currently addressed signal pattern group has been completed.

9. Use of the method according to one of Claims 1 to 8 for outputting a sequence of three-bit signal patterns for the bank select signals when testing high-speed dynamic semiconductor memory modules, in particular 256 M SDRAMs with four memory banks.

10. Device for carrying out the method according to one of Claims 1 to 8, **characterized by** a control logic circuit (2) for generating addresses for the buffer register (1), said control logic circuit (2) being connected to a buffer register (1) which is configured as the addressable memory for storing the signal patterns or signal pattern groups and the branch address (P), the control logic circuit (2) receiving the control signal (S) and the current address (BSA) and driving the buffer register (1).

11. Device according to Claim 10, **characterized in that** it is provided in an integrated semiconductor circuit (BOST) for testing high-speed dynamic digital circuits, in particular SDRAM memory modules for generating bank select signal, said integrated semiconductor circuit (BOST) being remote from a conventional test unit.

## Revendications

1. Procédé de production de configurations de signal électrique, numérique d'une fonction déterminée, par exemple des configurations de signal de données, dans lequel on forme dans une mémoire (1) qui peut être adressée une pluralité de groupes de configurations de signal qui comporte respectivement une pluralité de configurations (HSC1, HSC2, HSC3, HSC4) de signal différent et on mémorise la configuration de signal des groupes de configurations de signal respectivement sous une adresse propre aux groupes de configurations de signal respectif à l'avance dans la mémoire (1) et on les met à disposition sur un adressage correspondant en mémorisant dans la mémoire en outre une définition déterminant une succession de lecture des groupes de configurations de signal mémorisé,
on mémorise successivement dans la mémoire (1) la configuration de signal et les groupes de configurations de signal et on indique la définition déterminant la succession de lecture par une adresse (P) à saut mémorisé à l'avance, dans la mémoire (1) sous la même adresse (BSA) que chaque groupe de configuration de signal mémorisé, adresse à saut qui associe une position de mémoire pour un groupe de configurations de signal à lire immédiatement ensuite dans la mémoire (1) et
dans lequel en fonction de l'adresse (BSA) actuelle respective et d'un signal (S) de commande envoyé de l'extérieur ou bien on lit dans la mémoire (1) la configuration de signal du groupe de configurations de signal instantané dans la succession indiquée par l'adresse continue ou sa séquence de mémoire, ou bien dans une succession déterminée par l'adresse à saut respective,
**caractérisé en ce que** les configurations (HSC1, HSC2, HSC3, HSC4) de signal sont des configurations de signal de la même fonction et **en ce que** respectivement une même partie des bits (BSA3, BSA2, BSA1, BSAO) définissant l'adresse (P) à saut sont mémorisés ensemble avec respectivement l'une des configurations (HSC1, HSC2, HSC3, HSC4) de signal de chaque groupe de configurations de signal de sorte qu'après passage complet du groupe de configurations de signal toute l'adresse (P) à saut est mise à disposition.

2. Procédé suivant la revendication 1, **caractérisé en ce que** chaque groupe de configurations de signal indiqué par une adresse contient le même nombre de configurations de signal.

3. Procédé suivant la revendication 1 ou 2, **caractérisé en ce que** chaque groupe de configurations de signal indiqué par une adresse a quatre configurations de signal.

4. Procédé suivant la revendication 1, **caractérisé en ce que** certains ou tous les groupes de configurations de signal comportent un nombre différent de configurations de signal.

5. Procédé suivant l'une des revendications précédentes, **caractérisé en ce** chaque configuration de signal a trois positions binaires.

6. Procédé suivant l'une des revendication précédentes, **caractérisé en ce que**, lorsque le signal (S) de commande n'est pas activé, des configurations de signal continues du groupe de configurations de signal adressé instantanément sont sorties.

7. Procédé suivant l'une des revendication 1 à 5, **caractérisé en ce que**, lorsque le signal (S) de commande n'est pas activé, les groupes de configurations de signal mémorisés sont sortis en continu dans la succession indiquée par l'adressage continu ou par leur séquence de mémoire et **en ce qu'**après la sortie de la dernière configuration de signal, on poursuit avec la sortie de la première configuration de signal du premier groupe de configurations de signal.

8. Procédé suivant l'une des revendications 1 à 5, **caractérisé en ce que**, lorsque le signal (S) de commande est activé, après la sortie complète du groupe de configurations de signal adressé instantanément, a lieu le saut au début du groupe de configurations de signal venant immédiatement ensuite associé par l'adresse (P) à saut.

9. Utilisation du procédé suivant l'une des revendications 1 à 8, pour sortir une succession de configurations de signal à 3 bits pour les signaux bank-select lors de l'essai de modules de mémoire à semiconducteur dynamiques rapides, notamment de 256Ms DRAM ayant quatre banques de mémoire.

10. Dispositif pour la mise en oeuvre du procédé suivant l'une des revendications 1 à 8, **caractérisé par**
un circuit (2) de logique de commande, qui est relié à un registre (1) de mémoire intermédiaire, établit, en tant que mémoire adressable pour mémoriser la configuration de signal, des groupes de configurations de signal et l'adresse (P) à saut est destiné à produire des adresses pour le registre (1) de mémoire intermédiaire, le circuit (2) de logique de commande recevant le signal (S) de commande et l'adresse (BSA) instantanée et commandant le registre (1) de mémoire intermédiaire.

11. Dispositif suivant la revendication 10, **caractérisé en ce qu'**il est prévu dans un circuit (BOST) à semiconducteurs intégré à distance d'un appareil de test habituel pour le test de circuits numériques dynamiques rapides, notamment de modules de mémoire SDRAM pour la production de signaux bank-select.
